# EUROPEAN PATENT APPLICATION

(11) **EP 2 091 094 A2**
(43) Date of publication of application: **19.08.2009**
(21) Application number: 09152897.6
(22) Date of filing: 16.02.2009
(51) Int. Cl.: H01L 51/50

(54) **Organic light-emitting element**

(30) Priority: 14.02.2008 JP 2008033515; 26.12.2008 JP 2008332358
(71) Applicant: Yamagata Promotional Organization for Industrial Technology, Yamagata-shi Yamagata 990-2473 (JP)
(72) Inventor: Oda, Atsushi c/o Yamagata Promotional Org. for Ind. Tech., Yamagata 990-2473 (JP); Kimura, Masato c/o Yamagata Promotional Org. for Ind. Tech., Yamagata 990-2473 (JP); Tanaka, Junichi c/o Yamagata Promotional Org. for Ind. Tech., Yamagata 990-2473 (JP)
(74) Representative: HOFFMANN EITLE

(57) **Abstract**

To provide an organic light-emitting element using a fluorene derivative which allows a blue luminescent material excellent in color purity to emit light.
The organic light-emitting element having one or a plurality of organic layers including a light emitting layer between a pair of electrodes is arranged such that at least one layer of the above-mentioned organic layers contains a compound as expressed by the following general formula (1) independently or as a mixture, 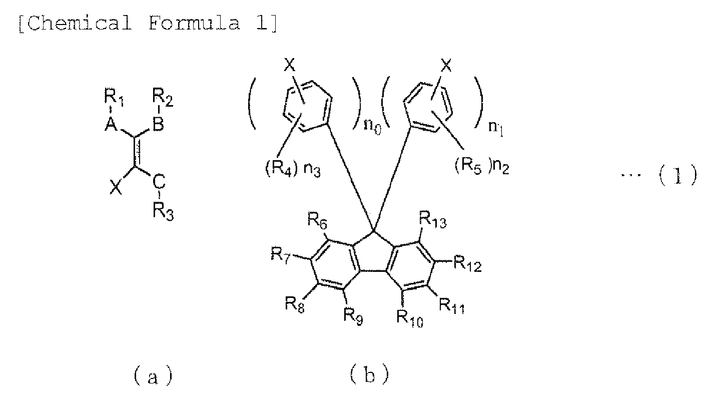 (A, B, C: hydrogen, substituted or unsubstituted phenylene group, naphthalene group, biphenylene group, fluorene group, or carbazole group. A and B may form a saturated ring bond. R₁-R₅: hydrogen, alkyl group, cycloalkyl group, alkoxy group, cycloalkoxy group. R₆-R₁₃: hydrogen, halogen, cycloalkyl group, alkoxy group, cycloalkoxy group, aryloxy group, substituted or unsubstituted phenylene group or biphenylene group. no, n₁: 1 or 2. n₂, n₃: integer from 1 to 8. X: single bond which connects unit (a) and unit (b).)

## Description

### BACKGROUND OF THE INVENTION

### Field of the Invention

The present invention relates to an organic light-emitting element containing a fluorene derivative which allows a blue luminescent material to emit light with high color purity.

### Description of the Related Art

Since the organic light-emitting element is a self-luminescence type element which includes an organic compound as a light emitting material and allows luminescence at a high speed, it is suitable for displaying a video image, and it has features that allow an element structure to be simple and a display panel to be thin, etc. Having such outstanding features, the organic light-emitting element is spreading in everyday life as a cellular phone display or a Vehicle-mounted display.

Further, unlike LED, taking advantage of the features that it allows planar luminescence and is thin and lightweight, technical development as an illumination panel light source has also been carried out.

Generally, the organic light-emitting element has a multilayer structure in which respective materials with a hole/electron injection function, transport function, or blocking function are laminated in order to realize high efficiency and a long-life.

However, in operation, the multilayer structure-type organic light-emitting element tends to cause degradation at an interface between the respective layers and has a problem that its luminous efficiency is reduced.

Thus, for the purpose of inhibiting the degradation at the interface between the layers, Japanese Patent Application Publication No. H11-251067 and Japanese Patent Application Publication No. H10-270171, for example, propose a method of doping an electron accepting dopant or an electron donating dopant in the organic layer, which is in contact with an electrode, in order to lower an energy barrier when injecting carriers from the electrode,

Further, in order to aim at improving the ability to inject holes or electrons from the electrode, Japanese Patent Application Publication No. 2000-315581 describes the multilayer-type organic light-emitting element provided with an organic semiconductor layer which is modified with an oxidizing dopant or a reducing dopant at the electrode interface. Furthermore, as for the element as disclosed in Japanese Patent Application Publication No. 2000-315581, a charge blocking layer is interposed between the organic semiconductor layer and a light emitting layer in order to obtain an effect of enclosing the carriers.

However, it is difficult for the method disclosed in the above-mentioned Japanese Patent Application Publication No. 2000-315581 to prevent the degradation caused by accumulation of charges at the interface, and there is a possibility of decrease in luminosity.

To cope with this, the present inventors have proposed an innovative means where the element is arranged to be controlled electronically and in physical properties without having a layer for preventing pass-through of the carriers (Japanese Paten Application No. 2007-38600).

However, this method has not sufficiently provided blue luminescence excellent in color purity except for yellow and green.

### SUMMARY OF THE INTENTION

The present invention arises in order to solve the above-mentioned technical problem, and aims at finding a fluorene derivative which allows a blue luminescence material excellent in color purity to emit light, and providing an organic light-emitting element using the fluorene derivative.

The organic light-emitting element having one or a plurality of organic layers including a light emitting layer between a pair of electrodes is arranged such that at least one layer of the above-mentioned organic layers contains a compound as expressed by the following general formula (1) independently or as a mixture,

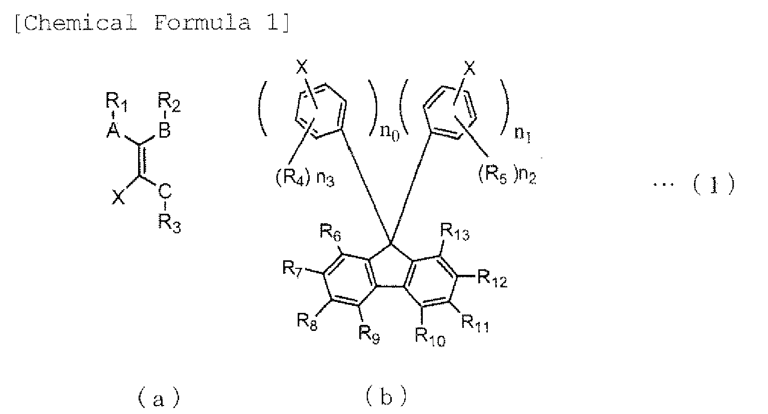

In the above-mentioned general formula (1), A, B, and C are substituents which are each independently selected from the group consisting of hydrogen, a substituted or unsubstituted phenylene group, a substituted or unsubstituted naphthalene group, a substituted biphenylene group, a substituted or unsubstituted fluorene group, and a substitute or unsubstituted carbazole group. A and B may be bonded together and may form a substituted or unsubstituted saturated ring bond. R₁-R₅ are substituents which are each independently selected from the group consisting of hydrogen, an alkyl group, a cycloalkyl group, an alkoxy group, and a cycloalkoxy group. R₆-R₁₃ are substituents which are each independently selected from the group consisting of hydrogen, halogen, a cycloalkyl group, an alkoxy group, a cycloalkoxy group, an aryloxy group, and a substituted or unsubstituted phenylene group, and a substituted or unsubstituted biphenylene group. n₀ and n₁ are each independently 1 or 2. n₂ and n₃ are each independently an integer from 1 to 8. X is a single bond which connects a unit (a) and a unit (b).

By using such a compound as an organic EL material, it is possible to provide an element which allows blue luminescence excellent in color purity.

As for the above-mentioned organic light-emitting element, it is preferable that the above-mentioned organic layers include a hole injection transport layer, a light emitting layer, and an electron injection transport layer, and at least one of the above-mentioned hole injection transport layer, the light emitting layer, and the electron injection transport layer contains the compound expressed by the above-mentioned general formula (1).

Further, as for the above-mentioned organic light-emitting element, it is preferable that plural sets of light emitting units including the hole injection transport layer, the light emitting layer, and the electron injection transport layer are laminated between a pair of electrodes, and a charge generating layer is formed between the above-mentioned respective light emitting units.

Further, a hole injection transport layer having an area where an oxidizing dopant is mixed with an organic compound of a hole injection transport material may be provided between a first electrode and the above-mentioned light emitting layer or the above-mentioned charge generating layer.

The compound expressed by the above-mentioned general formula
(1) can also be used for the hole injection transport layer by reaction with the oxidizing dopant.

Further, an electron injection transport layer having an area where a reducing dopant is mixed with an organic compound of an electron injection transport material may be provided between a second electrode and the light emitting layer.

The compound expressed by the above-mentioned general formula
(1) can also be used for the electron injection transport layer by reaction with the reducing dopant.

It is preferable that the above-mentioned oxidizing dopant is zinc oxide, aluminum oxide, tungstic oxide, vanadium oxide, rhenium oxide, molybdenum oxide, or ruthenium oxide.

Further, it is preferable that the above-mentioned light emitting layer has a deviation in the concentration of a light emitting dopant.

Furthermore, as for the above-mentioned electrode, it is preferable that a transparent electroconductive thin-film is formed on a transparent substrate.

As described above, according to the organic light-emitting element in accordance with the present invention, the blue luminescence excellent in color purity is obtained. Thus, it is possible to provide the white-light emitting element with high color rendering properties.

Therefore, it is expected that the organic light-emitting element in accordance with the present invention would be applied to flat panel displays for OA computers and flat TV sets which nowadays require better color reproducibility, a light source for an illumination apparatus, a light source for a copying machine, light sources which take advantage of planar light-emitting members, such as backlight sources for a liquid crystal display, meters, etc., a display board, and a beacon light.

### BRIEF DESCRIPTION OF THE DRAWINGS

FIG. 1 is a sectional view schematically showing a layer structure of an organic light-emitting element in accordance with Example 1.
FIG. 2 is a graph showing a light emission spectrum of the organic light-emitting element in accordance with Example 1.
FIG. 3 is a graph showing a light emission spectrum of an organic light-emitting element in accordance with Comparative Example 1.
FIG. 4 is a graph showing a light emission spectrum of an organic light-emitting element in accordance with Example 2.
FIG. 5 is a graph showing a light emission spectrum of an organic light-emitting element in accordance with Example 3.

### DESCRIPTION OF THE PREFERRED EMBODIMENTS

Hereafter, the present invention will be described in detail.

An organic EL material used in an organic light-emitting element in accordance with the present invention is a compound expressed by the above-mentioned general formula (1).

Such a fluorene derivative is a compound which allows a blue luminescent material to emit light with high color purity. By using this, it is possible to provide a white light emitting element with high color rendering properties.

In the above-mentioned general formula (1), A, B, and C are substituents which are each independently selected from the group consisting of hydrogen, a substituted or unsubstituted phenylene group, a substituted or unsubstituted naphthalene group, a substituted biphenylene group, a substituted or unsubstituted fluorene group, and a substituted or unsubstituted carbazole group. A and B may be bonded together and may form a substituted or unsubstituted saturated ring bond. R₁-R₅ are substituents which are each independently selected from the group consisting of hydrogen, an alkyl group, a cycloalkyl group, an alkoxy group, and a cycloalkoxy group. R₆-R₁₃ are substituents which are each independently selected from the group consisting of hydrogen, halogen, a cycloalkyl group, an alkoxy group, a cycloalkoxy group, an aryloxy group, a substituted or unsubstituted phenylene group, and a substituted or unsubstituted biphenylene group. n₀ and n₁ are each independently 1 or 2. n₂ and n₃ are each independently an integer from 1 to 8 and preferably 1 to 4. X is a single bond which connects a unit (a) and a unit (b).

Among the above-mentioned substituents, the substituted phenylene group, the naphthalene group, the biphenylene group, the fluorene group, and the carbazole group respectively indicate the phenyl groups substituted, by an alkyl group, a cycloalkyl group, an alkoxy group, a cycloalkoxy group, and an aryloxy group.

The alkyl group indicates a saturated aliphatic hydrocarbon group, preferably having 1 to 6 carbon atoms, more preferably 1 to 4 carbon atoms, such as for example, a methyl group, an ethyl group, a propyl group, a butyl group, etc., and it may be of a straight chain or may be of a branched chain.

The cycloalkyl group indicates a saturated alicyclic hydrocarbon group, preferably having 3 to 10 carbon atoms, more preferably 5 to 8 carbon atoms, such as for example, a cyclohexyl group, a norbornyl group, an adamantyl group, etc., and they may be either unsubstituted or substituted.

The alkoxy group indicates, for example, a saturated aliphatic hydrocarbon group through ether bonds, wherein the saturated aliphatic hydrocarbon group is preferably an alkyl group as defined above, such as a methoxy group etc., and it may be of a straight chain, or may be of a branched chain.

The cycloalkoxy group indicates a cyclic saturated aliphatic hydrocarbon group through ether bonds, wherein the cyclic saturated aliphatic hydrocarbon group is preferably a cycloalkyl group as defined above, such as for example a cyclohexyloxy group etc., and it may be either unsubstituted or substituted.

The aryloxy group indicates an aromatic hydrocarbon group through ether bonds, such as for example a phenoxy group etc., and the aromatic hydrocarbon group may be either unsubstituted or substituted, and has preferably 6 to 14 carbon atoms, more preferably 6 to 10 carbon atoms.

Among the compounds expressed by the above-mentioned general formula (1), structures of particular compounds are illustrated below. In addition, R in each compound as shown in the following [Chemical Formula 2] - [Chemical Formula 4] indicates hydrogen, or the substituted or unsubstituted phenylene group.

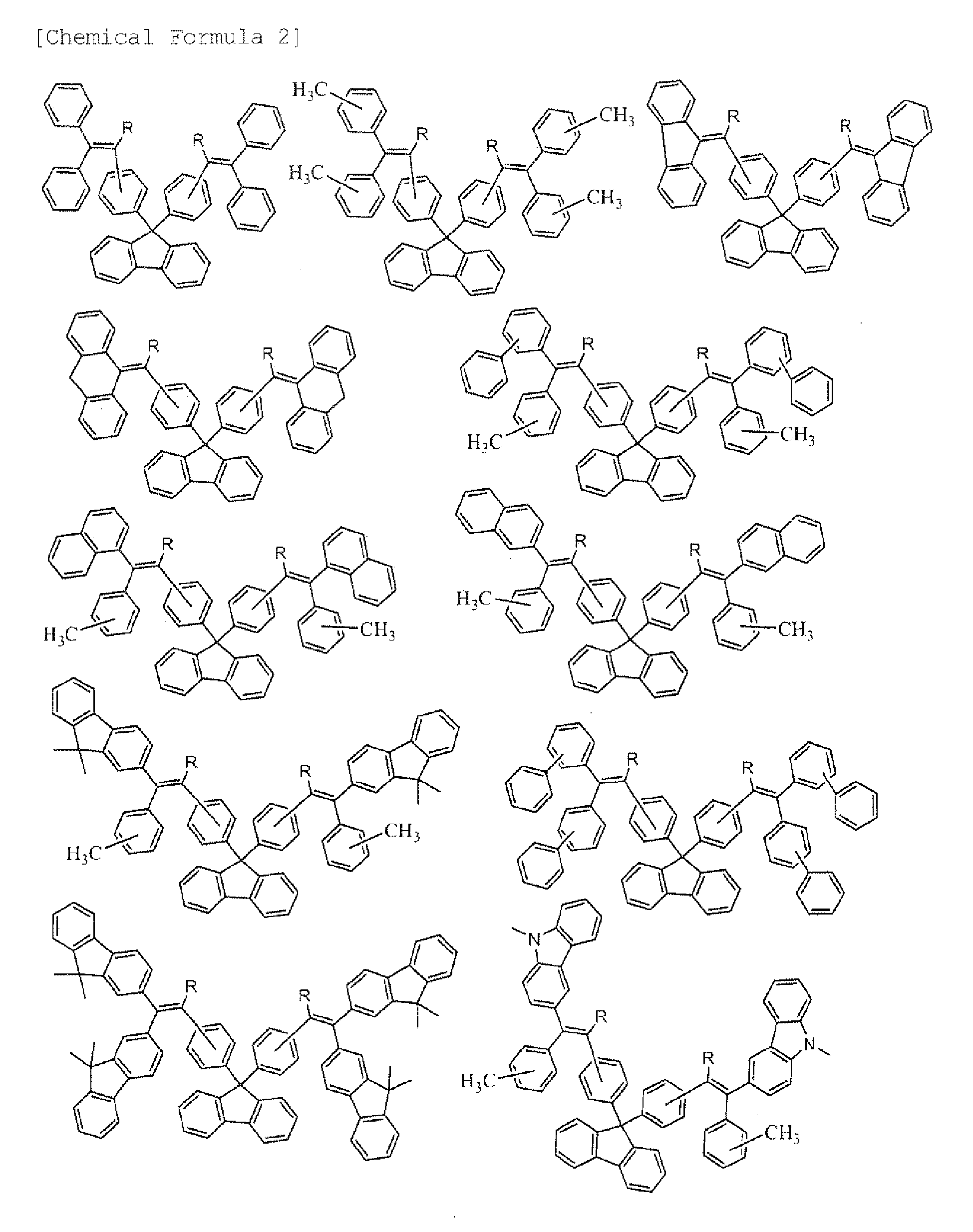

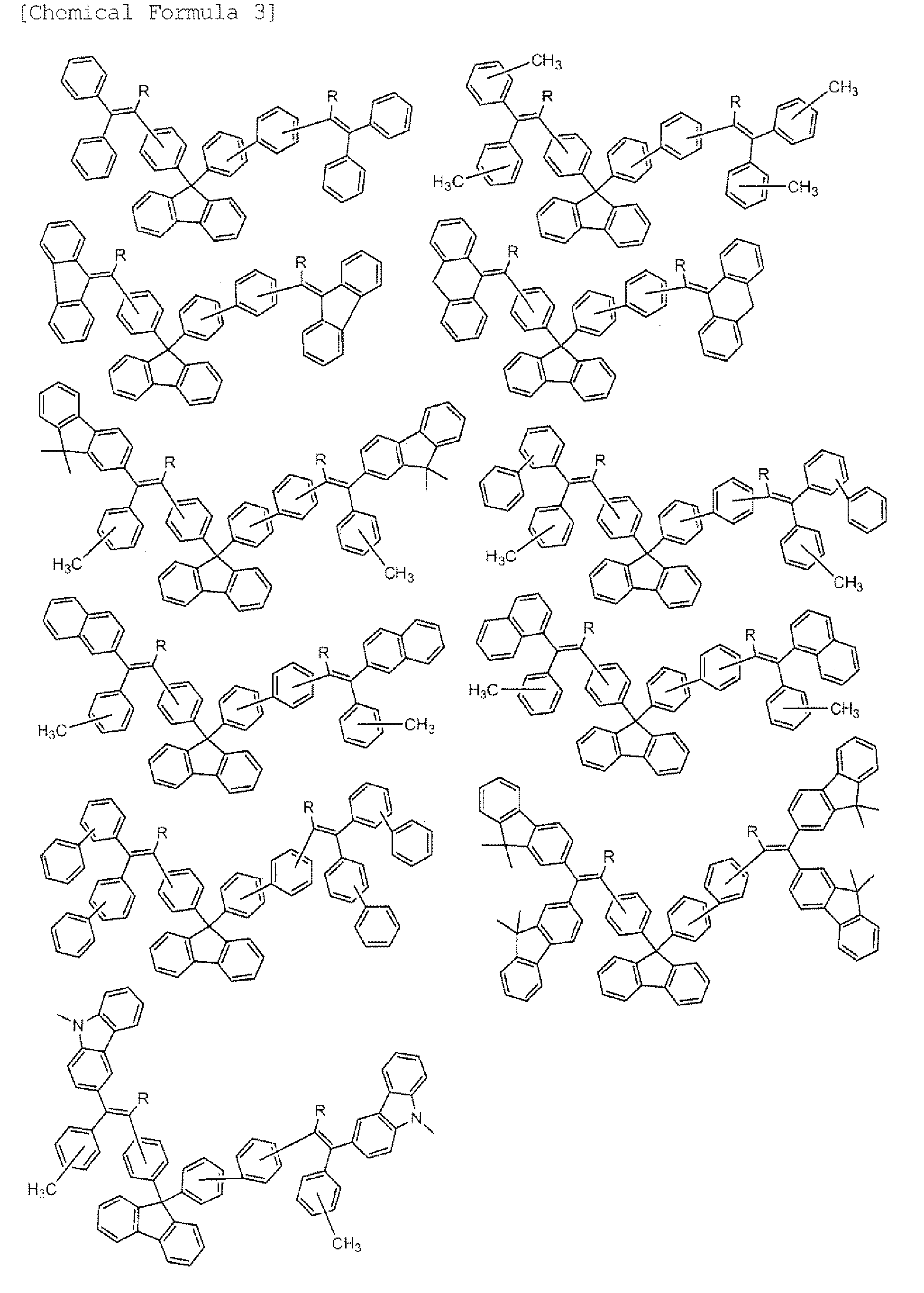

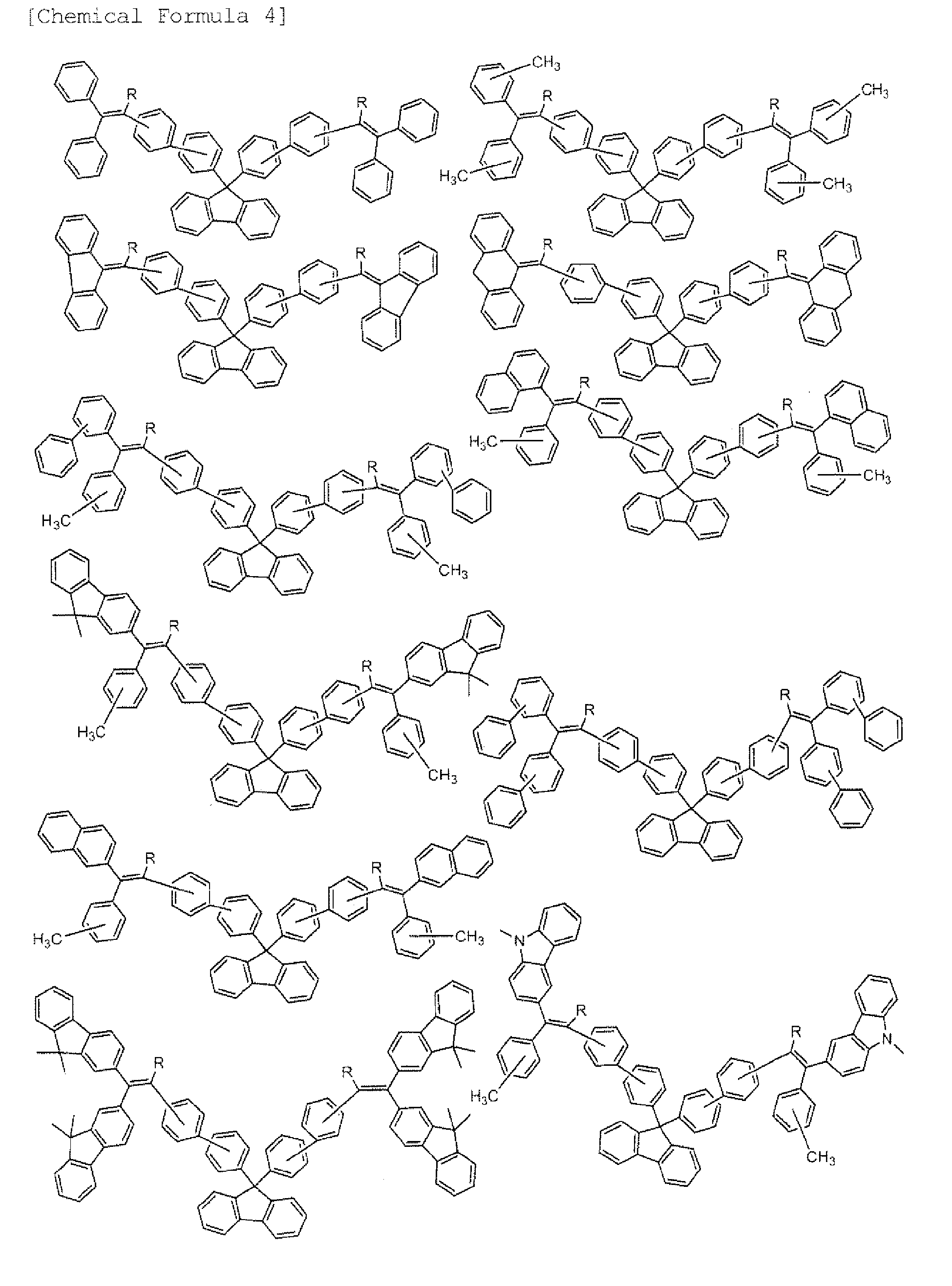

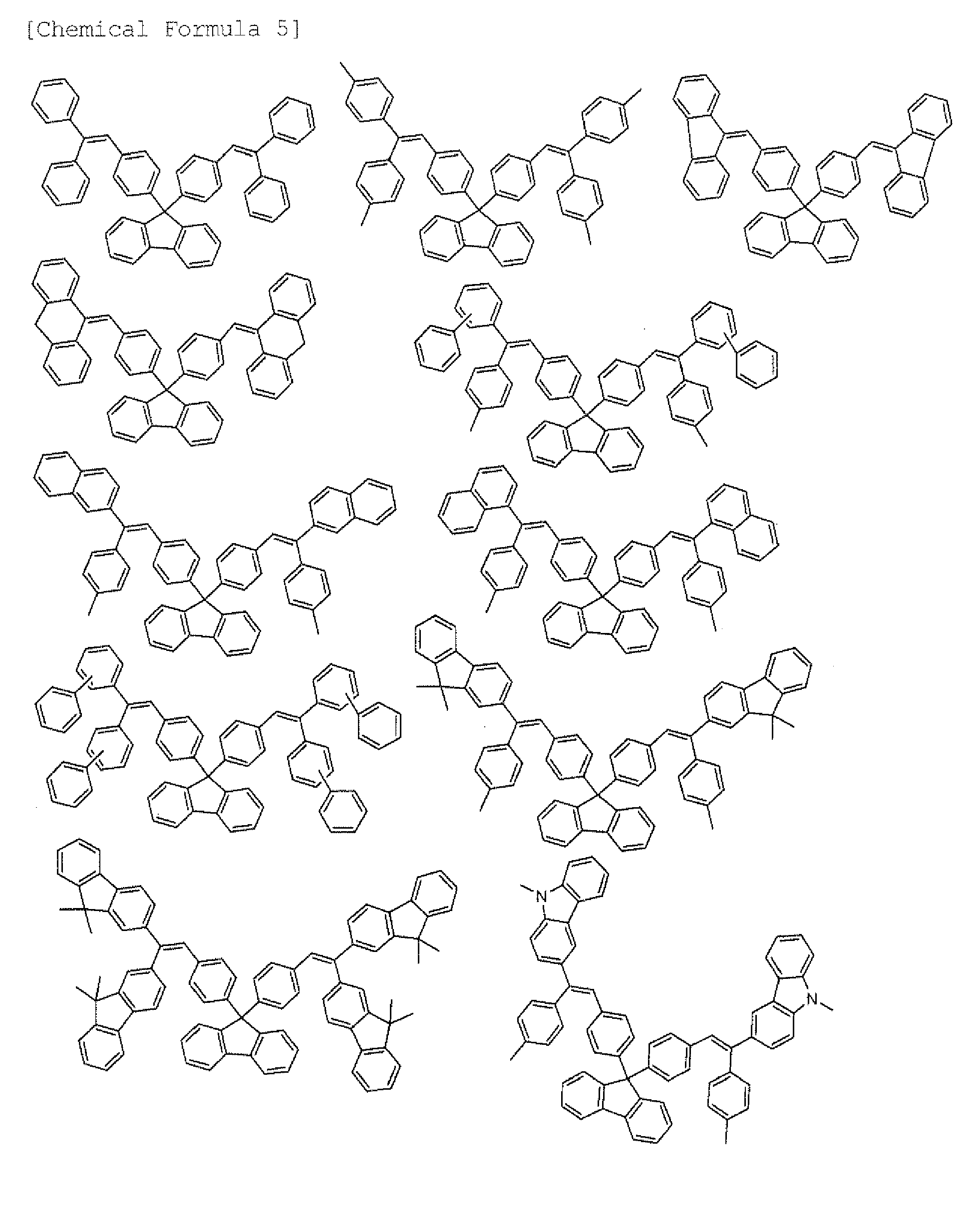

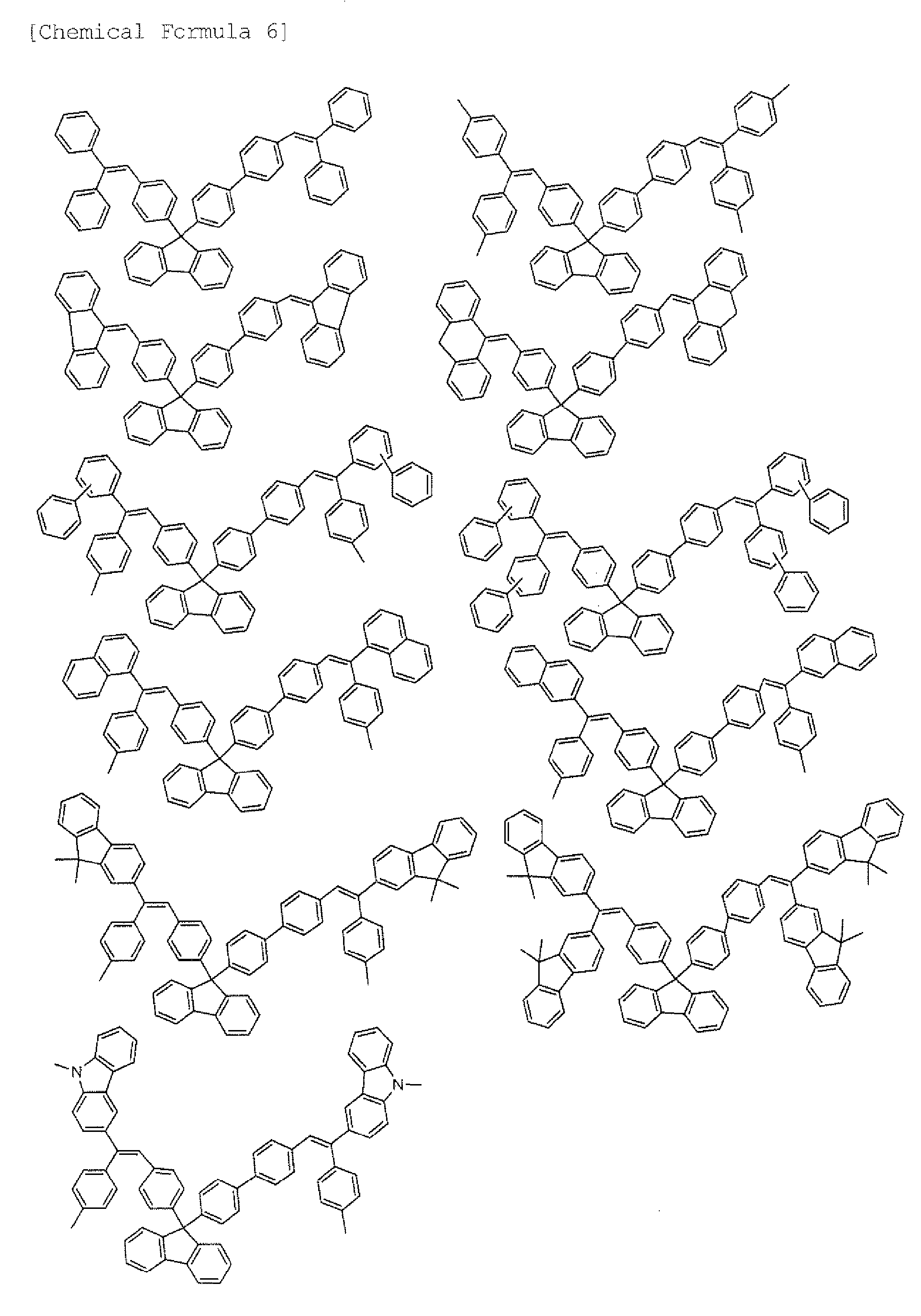

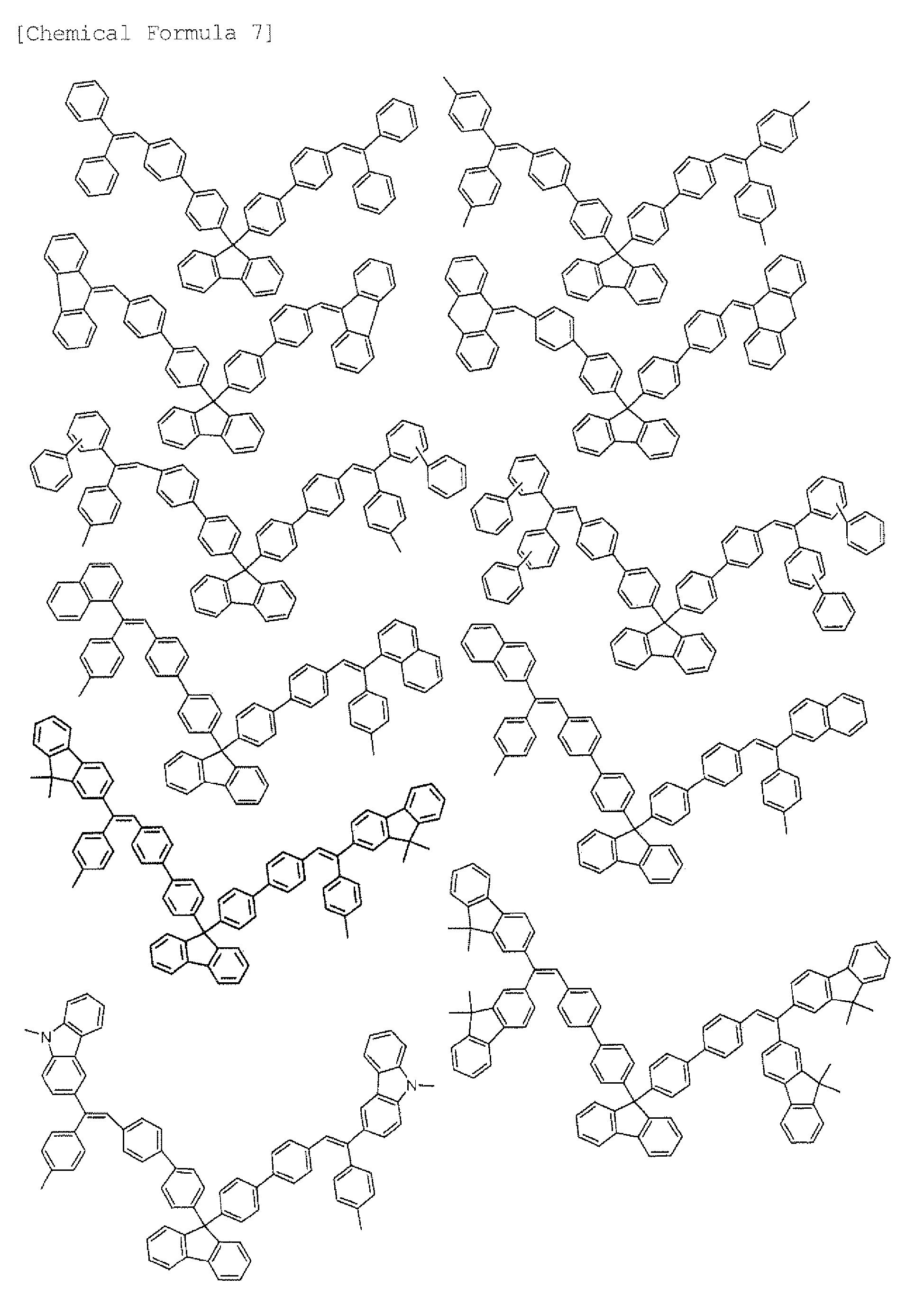

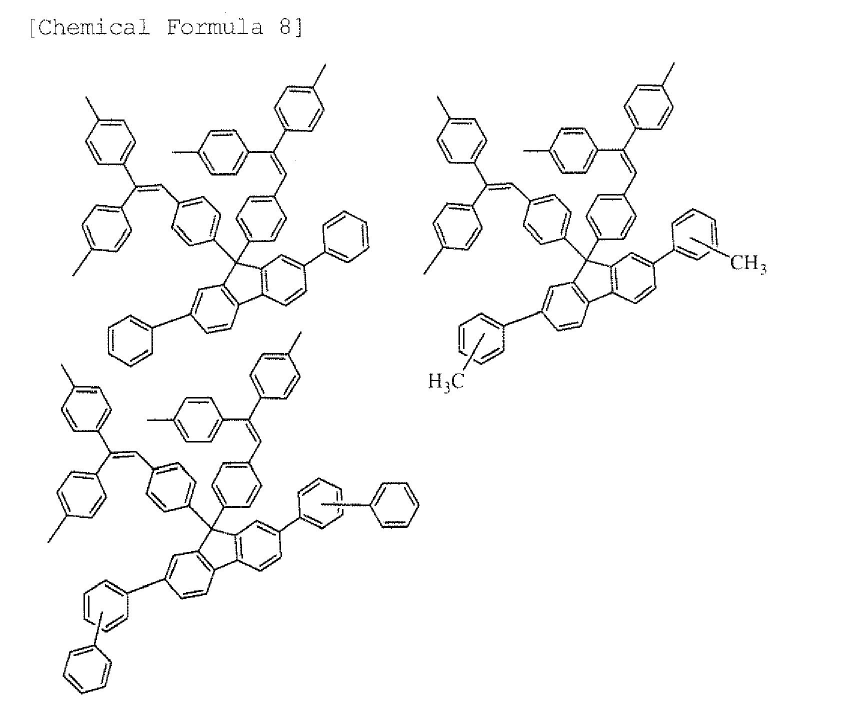

The compound expressed by the above-mentioned general formula
(1) may be synthesized by way of a conventional known synthetic reaction.

For example, it may be synthesized by way of a method of condensing carbonyl compounds in the presence of a base catalyst, such as the Wittig reaction, the Wittig-Horner reaction, etc. An example of the synthesis is shown below.

Using 2-halogenated biphenyl as a starting material, a nucleophilic reactant is prepared according to the Grignard reaction and lithiation. Then, it is reacted with a corresponding dimethylbenzophenone compound. At this time, an ether-type solvent is used for a reaction solvent. THF and CPME are particularly preferable.

After the reaction, acid treatment is carried out to change it into an alcoholic compound. Then, a ring is closed by an acid, such as acetic acid, to obtain a 9,9-dibenzylfluorene derivative. Subsequently, a benzyl part of this 9,9-dibenzylfluorene derivative is halogenated by a halogenation agent. NBS is particularly preferable as the halogenation agent.

Further, a phosphate derivative is synthesized by reaction of this halide with trialkyl phosphite. In the presence of a base, the compound expressed by the above-mentioned general formula (1) is synthesized by the Wittig-Horner reaction of the thus obtained phosphate derivative with a corresponding benzophenone compound.

At this time, as for the reaction solvent of the Wittig reaction, it is possible to use ether-type solvents, such as THF, diethyl ether, etc., and aprotic polar solvents, such as DMF, and DMSO, of which THF and DMSO are particularly preferable. Further, as for the base, it is possible to use bases, such as a metal hydroxide, sodium amide, hydrogenated sodium, alcoholates, such as t-BuONa, t-BuOK, etc. , and alkyl lithium, of which t-BuOK is particularly preferable.

In the above-mentioned synthesis, an asymmetrical compound expressed by the above-mentioned general formula (1) is also synthesized by selecting a corresponding benzophenone compound in the case of the Wittig reaction.

Further, by using fluorenone for a starting material, it is also possible to synthesize the asymmetrical compound expressed by the above-mentioned general formula (1).

Alternatively, by using a derivative of 9,9-bis(aryl halide)fluorene as the starting material, it is also possible to synthesize the compound expressed by the above-mentioned general formula (1) by way of coupling reaction using a transition metal catalyst, such as Pd etc. At this time, by respectively selecting a halogen group and a corresponding vinyl compound, it is also possible to synthesize the compound of the above-mentioned unsymmetrical general formula (1) in the case of the coupling reaction using the transition metal catalyst.

In addition, the starting material is not particularly limited, and it is possible to use a derivative of 9, 9-diaminophenyl fluorene, a derivative of 9,9-dialkoxyphenyl fluorene, a derivative of 9, 9-dihydroxyphenyl fluorene, etc. other than 2-halogenated biphenyl, fluorenone, and the derivative of 9, 9-dihaloaryl fluorene as mentioned above.

The organic light-emitting element in accordance with the present invention provided with the layer containing the compound expressed by the above-mentioned general formula (1) and allowing blue luminescence with high color purity, as described above, has a structure where one or a plurality of organic layers are laminated between the electrodes. As particular examples of the structure, there may be mentioned "first electrode / light emitting layer / second electrode", "first electrode / hole transport layer / light emitting layer / electron transport layer / second electrode", "first electrode / hole transport layer / light emitting layer / second electrode", "first electrode / light emitting layer / electron transport layer / second electrode", etc.

Furthermore, it is also possible to employ the known lamination structure further including a hole injection layer, a hole transport light-emitting layer, an electron injection layer, an electron transport light-emitting layer, etc.

In particular, it is preferable to include a lamination structure of "first electrode / hole injection transport layer / light emitting layer / electron injection transport layer / second electrode".

Further, the organic light-emitting element can also be used as a multi-element having a structure where light emitting units are connected in series in circuit, and these light emitting units emit light simultaneously.

Although a layer structure of each light emitting unit in the above-mentioned multi-element is not particularly limited, it is preferably arranged that plural sets of light emitting units, each set having "hole injection transport layer / light emitting layer / electron injection transport layer" laminated between the electrodes, are laminated between the light emitting units via the charge generating layer, for example. In other words, it is preferable to have a lamination structure like "first electrode / first light emitting unit (hole injection transport layer / light emitting layer / electron injection transport layer) / charge generating layer / second light emitting unit (hole injection transport layer / light emitting layer / electron injection transport layer) / ... / n-th light emitting unit (hole injection transport layer / light emitting layer / electron injection transport layer) / second electrode.

The compound which is expressed by the above-mentioned general formula (1) and is the organic EL material in accordance with the present invention may be used for any of the above-mentioned organic layers, and may be used and dispersed together with a hole transport material, a light emitting material, and an electron transport material. Further, a light emitting colorant may be doped in the dispersion.

Furthermore, the compound expressed by the above-mentioned general formula (1) can also be used for the hole injection transport layer by reaction with an oxidizing dopant, and for the electron injection transport layer by reaction with a reducing dopant.

As for the electrode of the organic light-emitting element in accordance with the present invention, it is preferable that a transparent electroconductive thin-film is formed on a transparent substrate.

The above-mentioned substrate is a support member of the organic light-emitting element. In the case where the substrate side is a light emitting side, it is preferable to use a transparent substrate which is transmissive in visible light. It is preferable that the optical transmissivity is 80% or more. More preferably, it is 85% or more. Most preferably, it is 90% or more.

In general, the above-mentioned transparent substrate employs glass substrates made of, such as for example, optical glass (BK7, BaK1, F2, etc.), silica glass, non alkali glass, borosilicate glass, aluminosilicate glass, polymer substrate made of, such as for example, acrylic resins (PMMA, etc.), polycarbonate, polyether sulphonate, polystyrene, polyolefin, an epoxy resin, and polyethylene terephthalate, polyester, etc.

Although the above-mentioned substrate having a thickness of approximately 0.1-10 mm is usually used, it is preferable that the thickness is 0.3-5 mm in view of mechanical strength, weight, etc. More preferably it is 0.5-2 mm.

Further, in the present invention, it is preferable that the first electrode is provided on the above-mentioned substrate. Although this first electrode is usually an anode and is made of a metal, an alloy, an electroconductive compound, etc., with a large work function (4 eV or more), it is preferable to be formed as a transparent electrode on the above-mentioned transparent substrate.

In general, metal oxides, such as indium tin oxide (ITO), indium zinc oxide, and zinc oxide, etc., are used for this transparent electrode. In particular, ITO is preferably used in terms of its transparency, conductivity, etc.

In order to secure the transparency and conductivity, it is preferable that a film thickness of this transparent electrode is 80-400 nm. More preferably, it is 100-200 nm.

It is preferable that the anode is usually formed by way of a sputtering method, a vacuum deposition method, etc., and formed as the transparent electroconductive thin-film.

On the other hand, in the case where the above-mentioned anode is the first electrode, a cathode of the second electrode which faces this anode is made of a metal, an alloy, and a conductive compound having a small work function (4 eV or less). As examples thereof, there may be mentioned aluminum, an aluminum-lithium alloy, a magnesium-silver alloy, etc.

It is preferable that a film thickness of the above-mentioned cathode is 10-500 nm. More preferably, it is 50-200 nm.

The above-mentioned anode and cathode can be formed by forming a film by way of methods usually used, such as a sputtering method, an ion plating method, a vapor-depositing method, etc.

The materials used for the above-mentioned hole injection layer, hole transport layer, and hole transport light-emitting layer are not particularly limited, but can be suitably selected from known materials to use.

In particular, they may be bis (di(p-trill) aminophenyl) -1, 1-cyclohexane (common name: TAPc), Spiro-TPD [Chemical Formula 9], N,N'-diphenyl-N,N'-bis(3-methylphenyl)-1,1'-biphenyl- 4,4'-diamine (common name: TPD), N,N'-diphenyl-N,N'-bis(1-naphthyl)-1,1'-biphenyl-4,4'-diamine (common name: α-NPD), TPTE [Chemical Formula 10], starburst amines [Chemical Formula 11], and arylamine derivatives, such as styrylamines (N20 [Chemical Formula 12], for example) etc.

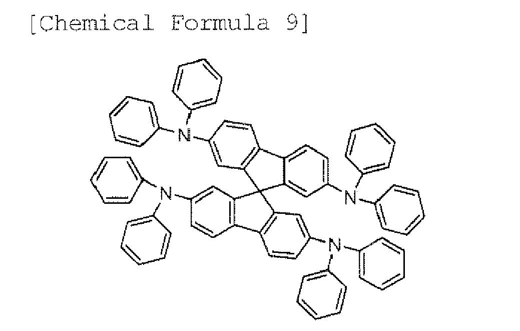

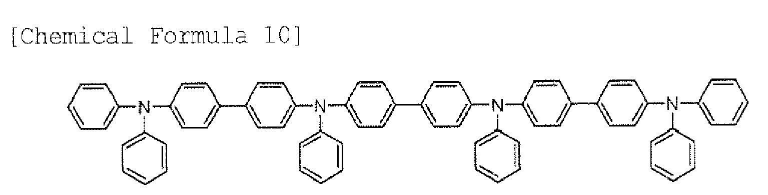

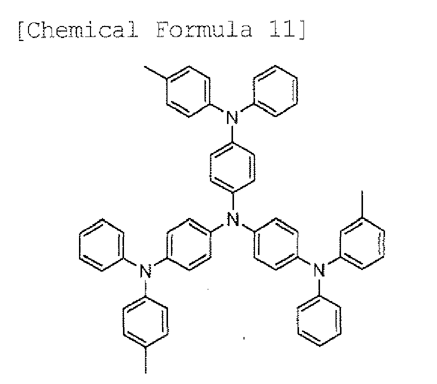

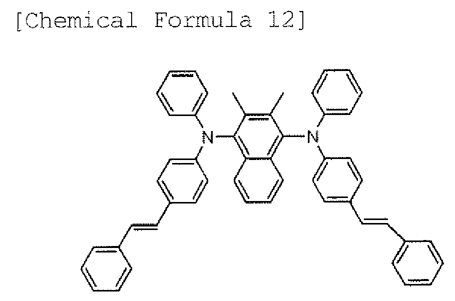

Further, it is also possible to use carbazole derivatives, such as bis(N-arylcarbazole) (common name: CBP) [Chemical Formula 13], bis(N-alkenylcarbazole), bis(N-alkylcarbazole), etc., a pyrazoline derivative, styryl compounds and their derivatives, such as sp-DPVBi [Chemical Formula 15], etc.

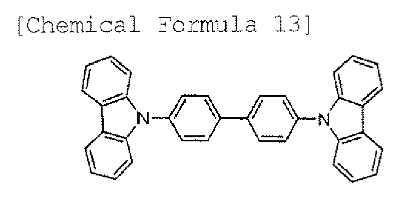

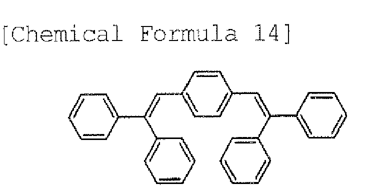

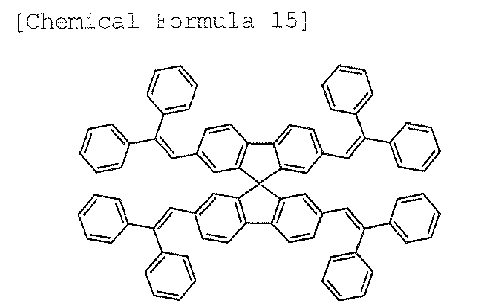

Alternatively, it is also possible to use fused multi-ring aromatic hydrocarbon compounds and their derivatives, such as anthracene, triphenylene, perylene, naphthalene (such as 4,4', 8,8'-tetra(3-methylphenyl)-2,2'-binaphthyl (common name: TMBN) [Chemical Formula 16], 1,3,5,7-tetra(3-methylphenyl)naphthalene (common name: TMN1357) [Chemical Formula 17], etc.), pyrene, coronene, chrysene, naphthacene, tetracene, phenanthrene, etc. as well as multi-ring compounds and their derivatives, such as paraterphenyl, quaterphenyl, m-phenylenes [Chemical Formula 18], etc.

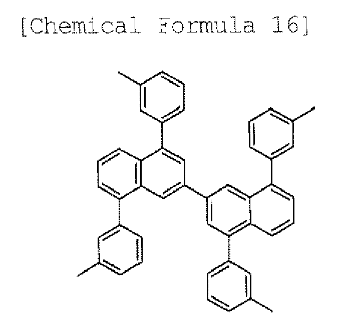

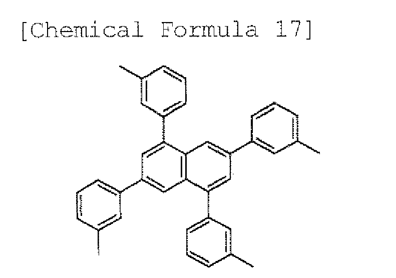

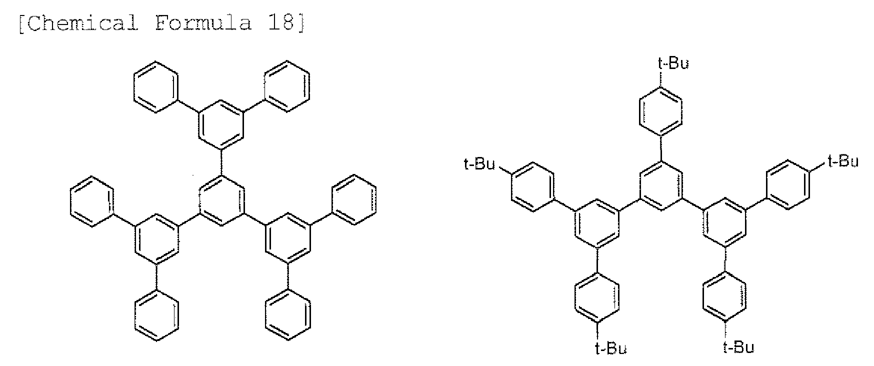

Further, the hole injection layer, the hole transport layer, and the hole transport light-emitting layer may employ the above-mentioned organic compound which is dispersed in a polymer, an oligomer, or a dendrimer, or which is polymerized, oligomerized or dendrimerized.

Furthermore, it is also possible to use so-called π-conjugated polymer, such as polyparaphenylenevinylene, polyfluorene, their derivatives, etc., a hole transport disconjugate polymer represented by poly(N-vinylcarbazole), σ-conjugated polymers represented by polysilanes, etc. Still further, so-called conjugated oligomers, such as for example a fluorene oligomer, its derivative, etc. can also be used.

Yet further, besides the above-mentioned materials, the hole injection layer may employ conductive polymers, such as metal phthalocyanines, non-metal phthalocyanines, carbon film, fluorocarbon film, polystyrene sulfonic acid (PEDOT-PSS), polyaniline, etc.

Furthermore, the above-mentioned organic compound may be reacted with organic oxidizing dopants, such as tetracyanoquinodimethane, trinitrotluorenone, etc., and inorganic oxidizing dopants, such as zinc oxide, aluminum oxide, tungstic oxide, vanadium oxide, rhenium oxide, molybdenum oxide, ruthenium oxide, etc. , to form a radical cation, and can be used as the hole injection transport layer. The oxidizing dopant concentration in the hole injection transport layer is not particularly limited, but it is preferable to be approximately 0.1 - 99 % by weight.

In addition, as described above, the fluorene derivative which is expressed by the above-mentioned general formula (1) and is the organic EL material in accordance with the present invention can also be used for the hole injection transport layer by reaction with the oxidizing dopant. Preferably, the oxidizing dopant in this case is vanadium oxide, rhenium oxide, or molybdenum oxide.

Respective materials used for the electron injection layer, electron transport layer, and electron transport light-emitting layer are not particularly limited, but can be suitably selected from known materials to use.

As particular examples, there may be mentioned multi-ring compounds and their derivatives, such as paraterphenyl, quaterphenyl, m-phenylenes [Chemical Formula 18], etc., and styryl compounds, such as [Chemical Formula 14], [Chemical Formula 15], and their derivatives.

Further, it is also possible to use fused multi-ring aromatic hydrocarbon compounds and their derivatives, such as anthracene, triphenylene, perylene, naphthalene, pyrene, coronene, chrysene, naphthacene, tetracene, phenanthrene, etc., as well as heterocyclic compounds and their derivatives, such as phenanthroline, bathophenanthroline, bathocuproin, phenanthridine, acridine, quinoline, quinoxaline, pyridine [Chemical Formula 19], pyrimidine, pyrrole, pyrazole, pyridazine, pyrazine, phthalazine, naphthylidine, quinazoline, cinnoline, thiazole, oxadiazole, oxazole, triazine, phenazine, imidazole, benzoxazole, benzothiazole, benzoimidazole, triazole, porphyrin, etc.

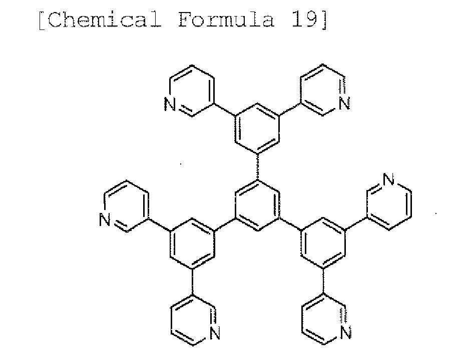

Further, it is also possible to use metal chelate complex materials, for example, a quinolinol aluminum complex, a benzoxazole zinc complex, a benzothiazole zinc complex, an azomethine zinc complex, a europium complex, an iridium complex, a platinum complex, etc., in which Al, Zn, Be, Ir, Pt, Tb, Eu, etc. are provided as central metals, and oxadiazole, thiadiazole, phenylpyridine, and quinoline structures are provided as ligands.

It is also possible to use organosilicon compounds and their derivatives, such as silole, siloxane, etc., organic boron compounds and their derivatives, such as triarylborane etc., and pentavalent phosphorus compounds and their derivatives etc., such as triarylphosphine oxide etc.

Furthermore, the electron injection layer, the electron transport layer, and the electron transport light-emitting layer may employ the above-mentioned organic compound which is dispersed in a polymer, an oligomer, or a dendrimer, or which is polymerized, oligomerized or dendrimerized.

Further, it is also possible to use the so-called π-conjugated polymers, such as polyparaphenylenevinylene, polyfluorene, their derivatives, etc., and the electron transport disconjugate polymers etc. represented by polyvinyl oxadiazole. Furthermore, so-called conjugated oligomers etc. , such as a fluorene oligomer, its derivative, etc. can also be used.

Besides the above-mentioned organic compounds, as for the constituent material of the electron injection layer, it is possible to use single metals, such as Ba, Ca, Li, Cs, Mg, Sr, W, etc., metal fluorides, such as magnesium fluoride, calcium fluoride, strontium fluoride, barium fluoride, lithium fluoride, cesium fluoride, etc., metal alloys, such as an aluminum lithium alloy etc., metal oxides, such as magnesium oxide, strontium oxide, aluminum oxide, etc., and organometallic complexes, such as sodium polymethylmethacrylate polystyrene sulfonate etc.

Furthermore, the above-mentioned organic compound may be reacted with an organic reducing dopant, such as 8-hydroxyquinoline Cs, Li organometallic complex, etc., to form a radical anion, which can be used as the electron injection transport layer.

Further, single metals, such as Ba, Ca, Li, Cs, Mg, Sr, W, etc., metal oxides, such as magnesium oxide, strontium oxide, aluminum oxide, etc., metal salts, such as magnesium fluoride, calcium fluoride, strontium fluoride, barium fluoride, lithium fluoride, cesium fluoride, cesium chloride, strontium chloride, etc., and inorganic reducing dopants may be mixed or dispersed to form a radical anion, which can be used as the electron injection transport layer.

Although the reducing dopant concentration in the above-mentioned electron injection transport layers is not particularly limited, it is preferable to be approximately 0.1 - 99 % by weight.

In addition, as described above, the fluorene derivative which is expressed by the above-mentioned general formula (1) and is the organic EL material in accordance with the present invention can also be used as the electron injection transport layer by reaction with the reducing dopant.

Further, it is possible to constitute the organic layer of the organic light-emitting element in accordance with the present invention by using a bipolar material. By bipolar material is meant a material which can convey both the hole and the electron and may emit light by itself.

The material used for the bipolar transport layer and a bipolar light-emitting layer is not particularly limited.

As examples thereof, there may be mentioned styryl compounds ([Chemical Formula 14], [Chemical Formula 15]) and their derivatives, multi-ring aromatic compounds and their derivatives, such as paraterphenyl, quaterphenyl, m-phenylene [Chemical Formula 18], etc., fused multi-ring aromatic hydrocarbon compounds and their derivatives, such as anthracene, triphenylene, perylene, naphthalenes ([Chemical Formula 16], [Chemical Formula 17]), pyrene, coronene, chrysene, naphthacene, tetracene, phenanthrene, etc., carbazole derivatives [Chemical Formula 13], such as bis(N-arylcarbazole), bis(N-alkenylcarbazole), bis(N-alkylcarbazole), etc., and heterocyclic compounds, such as and thiophene etc.

Further, as particular examples other than these derivatives etc., there may be mentioned 4,4-bis(2,2-diphenyl-ethene-1-yl)diphenyl (common name: DPVBi) [Chemical Formula 20], spiro6 [Chemical Formula 21], 2,2',7,7'-tetrakis(carbazole-9-yl)-9,9'-spiro-bifluorene [Chemical Formula 22], 4,4'-di(N-carbazolyl)-2',3',5',6'-tetraphenyl-p-terphenyl [Chemical Formula 23], 1,3-bis(carbazole)-9-yl)-benzene [Chemical Formula 24], and 3-tert-butyl-9,10-di(naphtha-2-yl)anthracene (common, name: TBADN) [Chemical Formula 25].

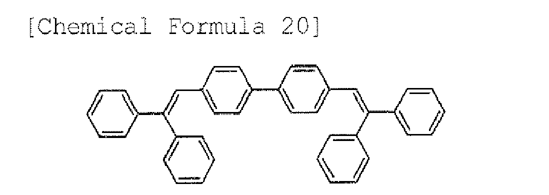

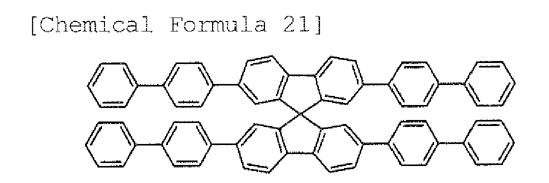

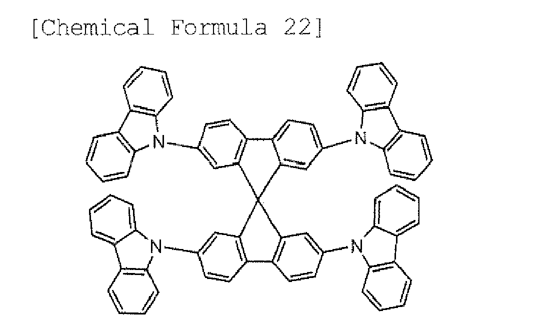

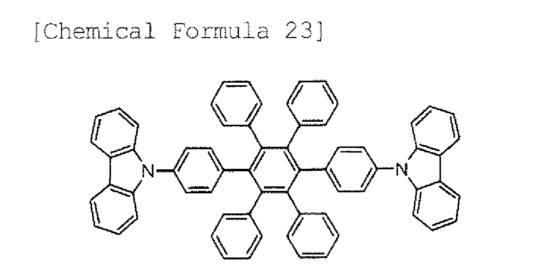

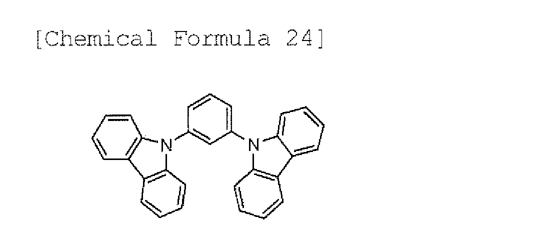

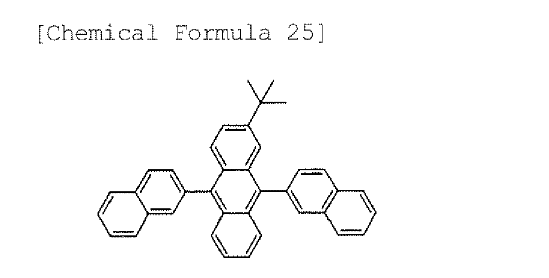

The bipolar material may employ the above-mentioned organic compound which is dispersed in a polymer, an oligomer, or a dendrimer, or which is polymerized, oligomerized or dendrimerized.

Further, it is also possible to use the so-called π-conjugated polymers, such as polyparaphenylene vinylene, polyfluorene, their derivatives, etc., and disconjugate polymers etc. represented by polyvinylcarbazole. Furthermore, so-called conjugated oligomers etc., such as a fluorene oligomer, its derivative, etc. can also be used.

Furthermore, copolymers, such as poly(vinyltriarylaminevinyloxadiazole) etc., where monomers having a hole transport function and an electron transport function exist in the same molecule, and a dendrimer can also be used.

Still further, it is possible to use the above-mentioned bipolar material which is reacted with the oxidizing dopant or reducing dopant as described above to form the hole injection layer or the electron injection layer. Especially, it is preferable that the oxidizing dopant is molybdenum oxide or vanadium oxide.

Although the organic EL material expressed by the above-mentioned general formula (1) can be used for the light emitting layer independently, it may be dispersed together with other hole transport material, light emitting material, electron transport material, etc., or doped, and can also be used combining with any of the above-mentioned organic layers.

In the organic light-emitting element in accordance with the present invention, it is especially preferable that the blue luminescent material is used as a guest material to form the light emitting layer where the organic EL material expressed by the above-mentioned general formula (1) is included as a host material. Further, it is possible to use it by combining with other host materials. It is preferable that the concentration of the organic EL material expressed by the above-mentioned general formula (1) in this case is 0.1 - 99 % by weight.

In the case where the organic EL material expressed by the above-mentioned general formula (1) is used as the host material of the light emitting layer, the guest material of the light emitting layer may be a fluorescence or phosphorescence emitting material.

As examples thereof, there may be mentioned multi-ring compounds and their derivatives, such as paraterphenyl, quaterphenyl, etc., styryl compounds ([Chemical Formula 14], [Chemical Formula 15]) and their derivatives, a tetraphenyl butadiene derivative, a pyrazoline derivative, an oxadiazole derivative, a coumarin derivative, a styrylamine derivative [Chemical Formula 12], and fused multi-ring aromatic hydrocarbon compounds and their derivatives, such as anthracene (such as TPA [Chemical Formula 26] etc.), triphenylene, perylene, naphthalenes ([Chemical Formula 16], [Chemical Formula 17], [Chemical Formula 27]), pyrene, coronene, chrysene, naphthacene, tetracene, phenanthrene, etc.

Further, it is also possible to use metal chelate complex materials, for example, a quinolinol aluminum complex, a benzoxazole zinc complex, a benzothiazole zinc complex, an azomethine zinc complex, a europium complex, a terbium complex, an iridium complex, a platinum complex, etc., in which Al, Zn, Be, Ir, Pt, Tb, Eu, etc. are provided as central metals, and oxadiazole, thiadiazole, phenylpyridine, and quinoline structures are provided as ligands. In particular, the metal chelate complexes represented by FIrpic [Chemical Formula 28] and their derivatives are mentioned.

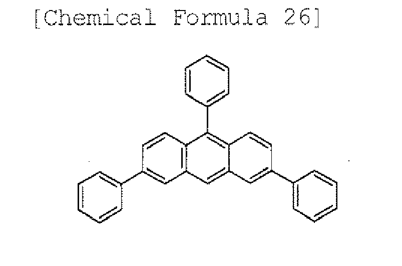

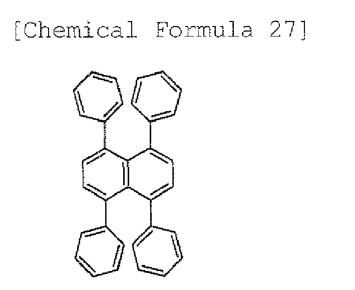

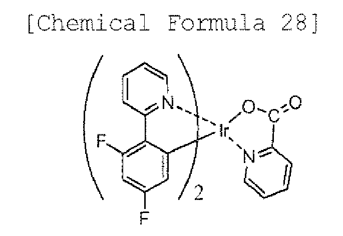

In addition, the light emitting layer may be made of the bipolar material as described above. The organic EL material expressed by the above-mentioned general formula (1) is included in the layer formed of the bipolar material independently or as a mixture, so that blue luminescence can also be obtained.

The bipolar material used for this light emitting layer may be a material which emits fluorescence or phosphorescence by itself. The bipolar material may be contained in any of the hole injection transport layer, the light emitting layer, and the electron injection transport layer.

The material expressed by the above-mentioned general formula
(1) may be used as the guest material, and a fluorescence or phosphorescence emitting material may be used for the host material.

As examples of the host material in this case, there may be mentioned, a naphthalene derivative [Chemical Formula 17], a m-phenylene derivative [Chemical Formula 18], ketone compounds and their derivatives, such as diarylketone etc., carbazole derivatives, such as bis(N-arylcarbazole) [Chemical Formula 13], bis(N-alkenylcarbazole), bis(N-alkylcarbazole), etc., and an iridium complex represented by Ir(ppz)₃ [Chemical Formula 29].

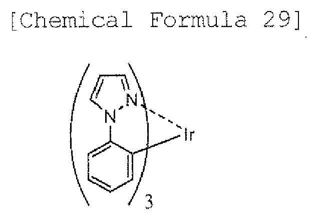

The above-mentioned host material may employ the above-mentioned organic compound which is polymerized, oligomerized or dendrimerized.

Further, it is also possible to use the so-called π-conjugated polymers, such as polyfluorene etc., and disconjugate polymers etc. represented by polyvinylcarbazole. Furthermore, so-called conjugated oligomers etc., such as a fluorene oligomer, its derivative, etc. can also be used.

Especially, it is preferable that the light emitting layer of the organic light-emitting element in accordance with the present invention contains at least one of the above-mentioned compounds [Chemical Formula 12], [Chemical Formula 16], [Chemical Formula 17], [Chemical Formula 26], and [Chemical Formula 27] in terms of obtaining blue luminescence with high color purity.

The formation of each of the above-mentioned organic layers can be performed by way of dry processes, such as a vacuum deposition process, a sputtering process, etc., and wet processes, such as an ink-jet process, a casting process, a dip coat process, a bar coat process, a blade coat process, a roll coat process, a photogravure coat process, a flexographic printing process, a spray coat process, etc. Preferably, the film formation is carried out by vacuum deposition.

Further, although a film thickness of each of the above-mentioned layers is suitably determined depending on its conditions in view of adaptability between the respective layers, the whole layer thickness to be required, etc., it is usually preferable to be within a range from 5 nm to 5 µm.

In the organic light-emitting element provided with the layer containing the organic EL material expressed by the above-mentioned general formula (1) independently or as a mixture, the blue luminescence having high color purity and provided by the organic EL material expressed by the above-mentioned general formula (1) is combined with green and red luminescence so that white luminescence with high color-rendering properties may be obtained.

As a particular method of obtaining white luminescence with high color-rendering properties, there may be mentioned a method of adding green luminescence and yellow to orange luminescence to the blue luminescence by the organic EL material expressed by the above-mentioned general formula (1) as complementary colors, a method of causing each of the blue, green, and red luminescent materials containing the material expressed by the above-mentioned general formula (1) to emit light independently, etc.

The above-mentioned green luminescent material or the red luminescent material may be a fluorescence or phosphorescence emitting material.

As examples thereof, there may be mentioned a quinacridone derivative, a squarylium derivative, a porphyrin derivative, a coumarin derivative, a dicyanopyrane derivative, arylamine compounds and their derivatives, such as anthracenediamine etc., fused multi-ring aromatic hydrocarbon compounds and their derivatives, such as perylene, rubrene, tetracene, decacyclene, etc., phenoxazone, a quinoxaline derivative, a carbazole derivative, and a fluorene derivative.

Further, it is also possible to use metal chelate complex materials, for example, a quinolinol aluminum complex, a benzoxazole zinc complex, a benzothiazole zinc complex, an azomethine zinc complex, a europium complex, a terbium complex, an iridium complex, a platinum complex, etc., in which Al, Zn, Be, Ir, Pt, Tb, Eu, etc. are provided as central metals, and oxadiazole, thiadiazole, phenylpyridine, and quinoline structures are provided as ligands. In particular, the metal chelate complexes represented by Ir (ppy)₃ [Chemical Formula 30], Irpiq₃ [Chemical Formula 31] and their derivatives are mentioned.

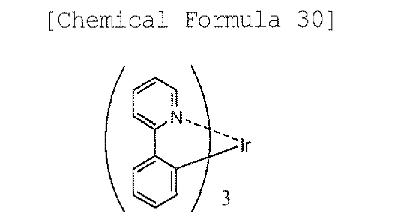

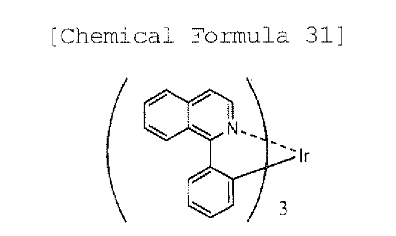

Hereafter, the present invention will be described still more particularly with reference to Examples. However, the present invention is not limited to the following Examples.

### [Example 1]

### (Synthesis of DTVPF)

According to a synthetic scheme as shown below, a compound (DTVPF) as shown in the following [Chemical Formula 32] was synthesized.

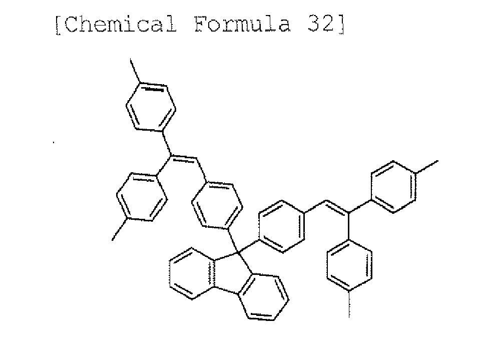

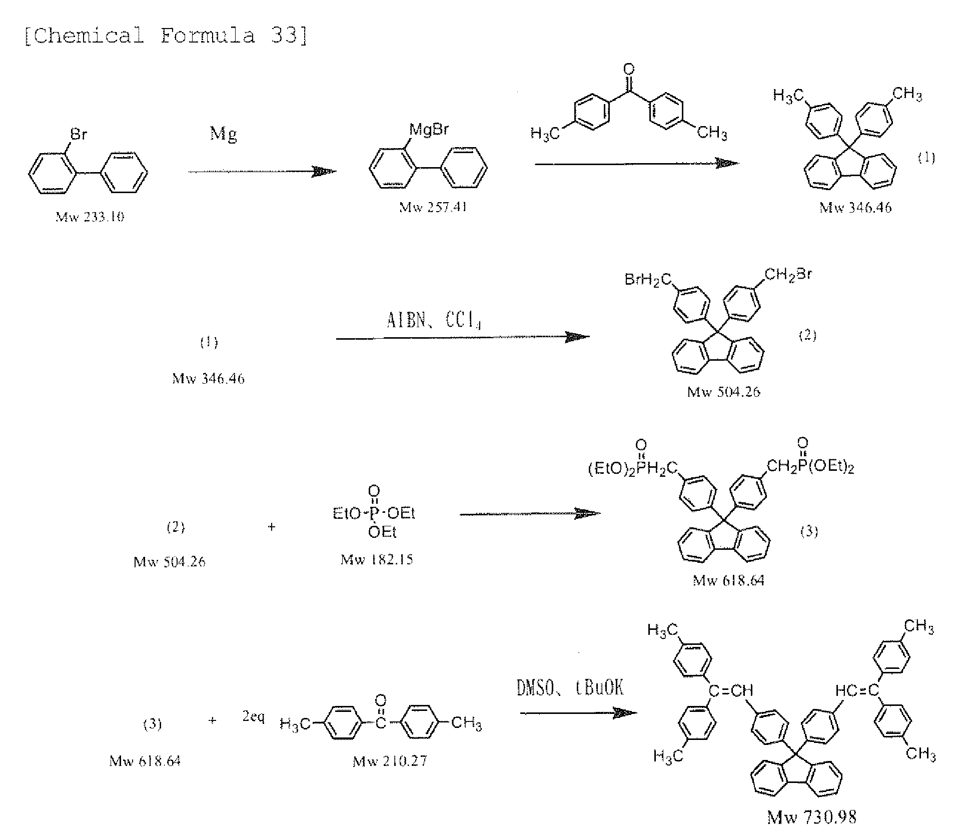

A piece, 1.6 g (65.64 mmol), of Mg and CPME were prepared in a flask in order. After nitrogen replacement, a CPME solution having dissolved therein 15.0 g (64.35 mmol) of 2-bromobiphenyl was fed into the Mg piece dispersion solution to react at 65 °C for 2.5 hours, and the Grignard reagent was prepared.

This reaction solution was cooled, and 13.8 g (65.64 mmol) of 4,4'-dimethylbenzophenone was fed into the solution to react at 65 °C for 4.0 hours. Then, the reaction solution was treated with hydrochloric acid.

An ether layer was washed twice with water. The residue after recovering the ether was dissolved in acetic acid, which was heated and stirred at 100 °C for 3.5 hours. After reducing its temperature to room temperature, precipitated crystals were filtered and washed with methanol.

The resultant crystal was white and powdery in appearance. As a result of structural analysis by MS, ¹H-NMR, the crystal was identified as 9,9-di-p-trill-9H-fluorene. Its yield was 14.7 g (65.9 % yield).

10.0 g (28.86 mmol) of 9,9-di-p-trill-9H-fluorene obtained as described above, 1.0 g (28.86 × 0.2 mmol) of AIBN, 11.0 g (28.86 × 2.1 mmol) of N-bromosuccinimide, and carbon tetrachloride were prepared in a flask, to react at 60 °C in a nitrogen atmosphere for 23 hours.

The reaction liquid was filtered. The solid matter was washed with carbon tetrachloride, and then refined by way of recrystallization from a mixed solvent of toluene:DMF.

The refined material was white and powdery in appearance. As a result of structural analysis by MS, ¹H-NMR, it was identified as 9,9-bis(4-bromomethyl-phenyl)-9H-fluorene. Its yield was 8.3 g (56.9 % yield).

8.0 g (15.86 mmol) of 9,9-bis(4-bromomethyl-phenyl)-9H-fluorene obtained as described above and 47.9 g (288.6 mmol) of triethyl phosphite were prepared in a reaction container, to react at 140 °C in a nitrogen atmosphere for 17 hours.

Excessive triethyl phosphite was collected from the reaction liquid, and the resultant crude material was refined by means of a silica gel column using a mixed solvent of chloroform:methanol as a developing solvent.

The refined material was white and solid in appearance. As a result of structural analysis by ¹H-NMR, MS, it was identified as a phosphate derivative which was the target. Its yield was 9.0 g (91.8% yield) .

3.0 g (4.849 mmol) of the phosphate obtained as described above, and 2.5 g (12.12 mmol) of 4,4'-dimethylbenzophenone, and DMSO were prepared in a reaction container. After nitrogen replacement, 2.7 g (24.24 mmol) of t-BuOK was fed into it at room temperature to react at room temperature for 23 hours.

Water was added to the reaction liquid and precipitated crystals were filtered, and the resultant crude material was refined by means of a silica gel column using a mixed solvent of chloroform:n-hexane as a developing solvent.

The refined material was white and powdery in appearance. As a result of structural analysis by ¹H-NMR, MS, it was identified as DTVPF. Its yield was 1.72 g (49.1 % yield).

Furthermore, this was sublimed and purified at 260 °C and 2. 3×10⁻⁴ Pa.

The resultant refined material had a melting point of 246.48 °C and a glass transition temperature (Tg) of 119.77 °C as a result of DSC (differential scanning calorimetry) measurement.

### (Preparation of Organic Light-Emitting Element)

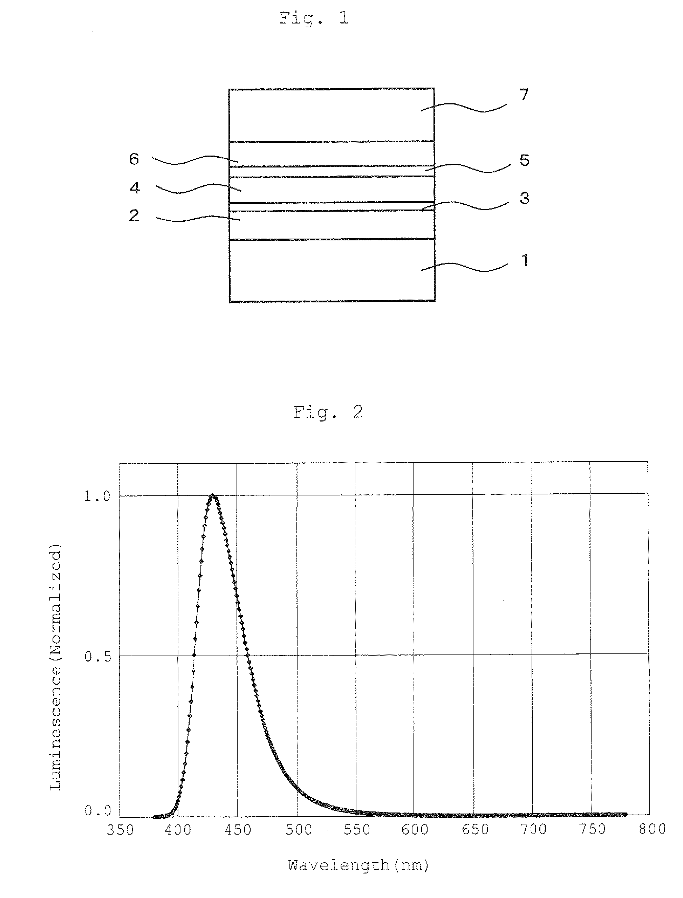

Using DTVPF as a hole injection transport material and an electron injection transport material, an organic light-emitting element having a layer structure as shown in FIG. 1 including a light emitting layer containing TMBN [Chemical Formula 16] and N20 [Chemical Formula 12] was prepared according to the following methods.

### (First Electrode)

First, a glass substrate having formed thereon a patterned transparent electroconductive film (ITO) with a film thickness of 150 nm was subjected to washing treatment in the order of ultrasonic cleaning by pure water and a surfactant, washing with flowing pure water, ultrasonic cleaning by a 1:1 mixed solution of pure water and isopropyl alcohol, and boiling washing by isopropyl alcohol. This substrate was slowly pulled up from the boiling isopropyl alcohol, and dried in isopropyl alcohol vapor, and, finally ultraviolet ozone cleaning was performed.

This substrate was used as an anode 1 and placed in a vacuum chamber which was evacuated to 1×10⁻⁶ Torr. In this vacuum chamber, each molybdenum boat filled up with a vapor deposition material and a vapor deposition mask for forming a film in a predetermined pattern were placed, the above-mentioned boat was electrically heated, and the vapor deposition material was evaporated to thereby form each organic layer one by one.

### (Hole Injecting Transport Layer)

By using DTVPF as a hole transport material together with molybdenum trioxide (MoO₃), the respective boats were electrically heated at the same time to carry out co-deposition. A hole injection layer 2 of DTVPF:MoO₃=67:33 was formed to have a film thickness of 10 nm.

Next, a hole transport layer 3 made only of DTVPF was formed to have a film thickness of 56 nm.

### (Light Emitting Layer)

A light emitting layer 4 of TMBN:N20=94:6 was formed to have a film thickness of 15 nm.

### (Electron Injecting Transport Layer)

An electron transport layer 5 made only of DTVPF was formed to have a film thickness of 38 nm, on which an electron injection layer 6 of DTVPF:Liq=50:50 was formed to have a film thickness of 10 nm.

### (Second Electrode)

While maintaining the vacuum chamber at a vacuum, masks were replaced to install masks for cathode vapor deposition. An aluminum (Al) layer was formed having a film thickness of 100 nm to be a cathode 7.

The vacuum chamber was returned to ambient pressure, and the substrate on which each layer was deposited as described above was taken out, and it was moved in a glove box in which nitrogen replacement was carried out. By using a UV curing resin, it was sealed with another glass board to obtain an organic light-emitting element.

A layer structure of this element may be simplified and shown as being ITO(150 nm) / DTVPF:MoO₃ (10 nm, 67:33) / DTVPF(56 nm) / TMBN:N20 (15 nm, 94:6) / DTVPF (38 nm) / DTVPF:Liq (10 nm, 50 %) / Al (100nm).

A direct-current voltage of 10 V was applied to this organic light-emitting element, then blue luminescence originated from N20 was obtained. A light emission spectrum of this organic light-emitting element is shown in FIG. 2.

An external quantum efficiency at a current density of 100 A/m² of the element was 0.89 %, and a visual luminous efficiency was 0.11 lm/W.

Further, chromaticity of this luminescence color was (x, y) = (0.157, 0.044) in CIE coordinates (100 A/m²), and it was confirmed as being blue luminescence excellent in color purity.

### [Comparative Example 1]

Instead of DTVPF in the element of Example 1, sp-DPVBi [Chemical Formula 15] was used. Except for this, the organic light-emitting element was prepared as with Example 1.

A layer structure of this element may be simplified and shown as being ITO(110 nm) / sp-DPVBi:MoO₃(10 nm, 67:33) / sp-DPVBi(35 nm) / TMBN:N20(20 nm, 94:6) / sp-DPVBi (45 nm) / sp-DPVBi:Liq (12nm, 50:50) / Al (100nm).

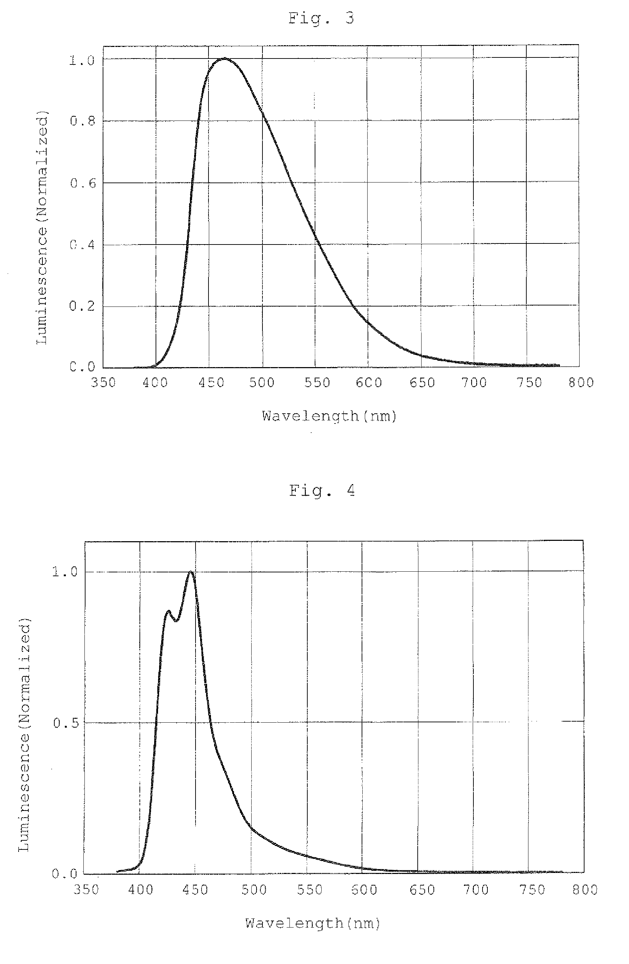

A direct-current voltage of 10 V was applied to this organic light-emitting element, then luminescence originated from N20 was obtained slightly. But, the blue luminescence with high color purity like Example 1 was not obtained. A light emission spectrum of this organic light-emitting element is shown in FIG. 3.

### [Example 2]

As with Example 1, an organic light-emitting element was prepared having a layer structure as shown in FIG. 1 including a light emitting layer which used TMN1357 [Chemical Formula 17] as a host material and TPA [Chemical Formula 26] as a light emitting dopant.

A layer structure of this element may be simplified and shown as being ITO(150 nm) / DTVPF: MoO₃ (10nm, 67:33) / DTVPF (56nm) / TMN1357:TPA(20 nm, 98:2) / DTVPF(15 nm) / DTVPF:Liq (10 nm, 50:50) / Al (100nm).

A light emission spectrum at the time of supplying a direct current of 1000 A/ m² to this organic EL element is shown in FIG. 4.

As shown in FIG. 4, pure blue luminescence originated from TPA was obtained.

Further, the chromaticity of this luminescence color was (x, y) = (0.165, 0.083) in CIE coordinates (1000 A/ m²), and it was confirmed as being blue luminescence with high color purity.

### [Example 3]

As with Example 1, an organic light-emitting element was prepared having a layer structure as shown in FIG. 1 including a light emitting layer which used TMN1357 [Chemical Formula 17] as a host material and N20 [Chemical Formula 12] as a light emitting dopant.

A layer structure of this element may be simplified and shown as being ITO(150 nm) / DTVPF: MoO₃ (10 nm, 67:33) / DTVPF(56 nm) / TMN1357:N20(15 nm, 94:6) / DTVPF(38 nm) / DTVPF:Liq (10 nm, 50:50) / Al (100nm).

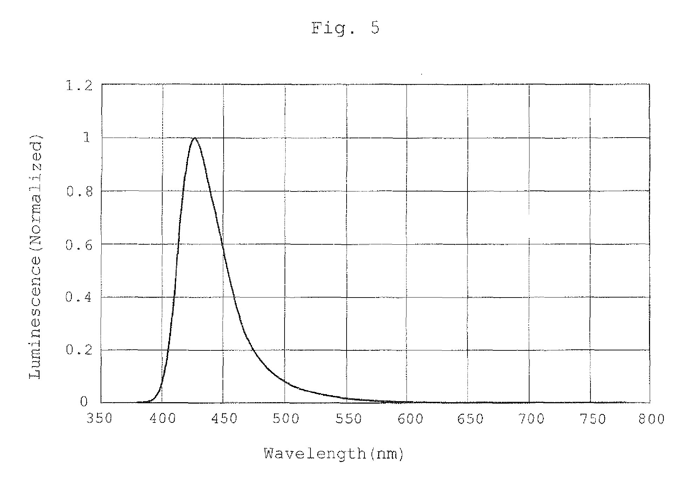

A light emission spectrum at the time of supplying a direct current of 100 A/ m² to this organic EL element is shown in FIG. 5.

As shown in FIG. 5, pure blue luminescence originated from N20 was obtained.

Further, the chromaticity of this luminescence color was (x, y) = (0.157, 0.043) in CIE coordinates (100 A/m²), and it was confirmed as being blue luminescence with high color purity.

As described above, according to the organic light-emitting element using the compound expressed by the general formula (1) in accordance with the present invention, it was confirmed that blue luminescence with high color purity was obtained.

Further, it is also confirmed that the layer doped with the oxidizing dopant and containing the compound expressed by the general formula (1) can be used as the electron injection layer, and that the layer doped with the reducing dopant and containing the compound expressed by the general formula (1) can be used as the electron injection layer.

Therefore, it is expected that the organic light-emitting element in accordance with the present invention would be applied to a display element and a light source in which excellent color purity is required.

## Claims

1. An organic light-emitting element having one or a plurality of organic layers including a light emitting layer between a pair of electrodes, wherein at least one layer of said organic layers contains a compound expressed by the following general formula (1) independently or as a mixture, 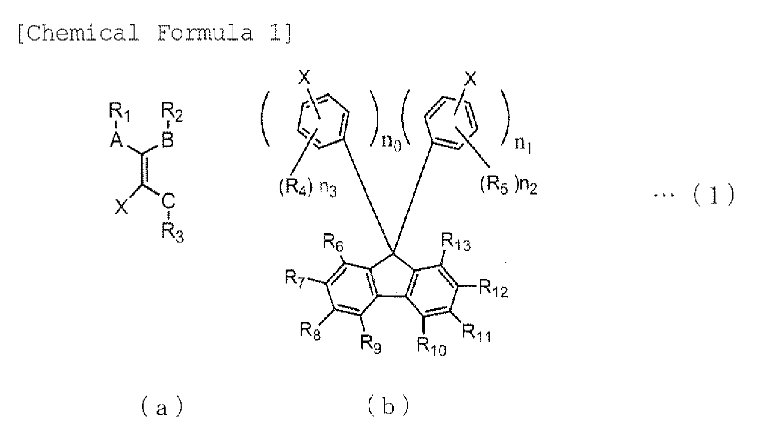 where A, B, and C are substituents which are each independently selected from the group consisting of hydrogen, a substituted or unsubstituted phenylene group, a substituted or unsubstituted naphthalene group, a substituted biphenylene group, a substituted or unsubstituted fluorene group, and a substituted or unsubstituted carbazole group, A and B may be bonded together and may form a substituted or unsubstituted saturated ring bond, R₁-R₅ are substituents which are each independently selected from the group consisting of hydrogen, an alkyl group, a cycloalkyl group, an alkoxy group, and a cycloalkoxy group, R₆-R₁₃ are substituents which are each independently selected from the group consisting of hydrogen, halogen, a cycloalkyl group, an alkoxy group, a cycloalkoxy group, an aryloxy group, and a substituted or unsubstituted phenylene group, and a substituted or unsubstituted biphenylene group, no and n₁ are each independently 1 or 2, n₂ and n₃ are each independently an integer from 1 to 8, and X is a single bond which connects a unit (a) and a unit (b).

2. The organic light-emitting element as claimed in claim 1, wherein said organic layer includes a hole injection transport layer, the light emitting layer, and an electron injection transport layer, and at least one of said hole injection transport layer, light emitting layer, and electron injection transport layer contains the compound expressed by said general formula (1).

3. The organic light-emitting element as claimed in claim 2, wherein plural sets of light emitting units including the hole injection transport layer, light emitting layer, and electron injection transport layer are laminated between the pair of electrodes, and a charge generating layer is formed between said light emitting units.

4. The organic light-emitting element as claimed in claim 1, wherein a hole injection transport layer having an area where an oxidizing dopant is mixed with an organic compound of a hole injection transport material is provided between a first electrode and said light emitting layer or said charge generating layer.

5. The organic light-emitting element as claimed in claim 1, wherein an electron injection transport layer having an area where a reducing dopant is mixed with an organic compound of an electron injection transport material is provided between a second electrode and the light emitting layer.

6. The organic light-emitting element as claimed in claim 4, wherein said oxidizing dopant is zinc oxide, aluminum oxide, tungstic oxide, vanadium oxide, rhenium oxide, molybdenum oxide, or ruthenium oxide.

7. The organic light-emitting element as claimed in claim 1, wherein said light emitting layer has a deviation in the concentration of a light emitting dopant.

8. The organic light-emitting element as claimed in claim 1, wherein said electrode is such that a transparent electroconductive thin-film is formed on a transparent substrate.
